# EUROPÄISCHE PATENTSCHRIFT

(11) **EP 3 214 763 B1**
(45) Veröffentlichungstag und Bekanntmachung des Hinweises auf die Patenterteilung: **06.09.2023**
(21) Anmeldenummer: 16157992.5
(22) Anmeldetag: 01.03.2016
(51) Int. Cl.: H03K 17/96

(54) **BETÄTIGUNGSPLATTE MIT SYMBOLBELEUCHTUNG FÜR EINEN SENSORSCHALTKNOPF**
ACTUATION PLATE WITH ICON ILLUMINATION FOR A SENSOR SWITCH BUTTON
PLAQUE D'ACTIONNEMENT COMPRENANT UN ECLAIRAGE DE SYMBOLE POUR UN BOUTON DE COMMANDE DE CAPTEUR

(43) Veröffentlichungstag der Anmeldung: 06.09.2017
(73) Patentinhaber: Aptiv Technologies Limited, St. Michael (BB)
(72) Erfinder: REISCHL, Erik, 55765 Birkenfeld (DE)
(74) Vertreter: Vigand, Philippe

(56) Entgegenhaltungen:
- EP-A1- 2 048 779
- EP-A2- 2 611 034
- DE-A1-102010 045 194
- DE-A1-102014 201 177
- DE-U1-202013 011 516
- US-A1- 2004 017 687
- US-A1- 2006 207 867
- US-A1- 2011 037 728
- US-A1- 2012 217 147

## Beschreibung

Die Erfindung betrifft eine Betätigungsplatte mit Symbolbeleuchtung für einen Sensorschaltknopf zum Einsatz in einer Schalteranordnung eines Fahrzeuges.

Seit einigen Jahren sind Schalter die durch ein Antippen mit dem Finger zu bedienen sind in Fahrzeugen im Einsatz. Diese Schalter sind sehr vorteilhaft, da sie keine mechanischen Komponenten benötigen und dadurch sehr robust sind. Diese Schalter wurden in Fahrzeugen zum Schalten verschiedener Funktionen eingesetzt. Unglücklicherweise können sich Kinder die beim Spielen im Innenraum eines Fahrzeugs unbeabsichtigt mit einem Körperteil wie Knie oder Fuß solch einen Schalter betätigen verletzen. Wird zum Beispiel ein elektrisches Schiebedach durch das Kind mit dem Fuß betätigt, während sich zeitgleich ein Körperteil in der Öffnung des Schiebedachs befindet, kann es zu ernsthaften Verletzungen kommen. Dieser Umstand macht es notwendig, Sensoren zu entwickeln, die erkennen wie groß die Berührungsfläche des Gegenstands ist. Ein Kapazitätssensor der dazu geeignet ist, die Größe einer Fingerspitze von größeren Körperteilen, wie zum Beispiel einem Handballen, zu unterscheiden, lässt sich relativ preiswert herstellen. Ein solcher Sensor läst sich herstellen, indem die Kupferbeschichtung einer handelsüblichen Leiterplatte (PCB) in adäquate Flächen aufgeteilt wird und die Flächen durch schmale Spalten voneinander getrennt sind. Diese separaten Flächen werden elektrisch an eine Auswerteelektronik angeschlossen. Diese Flächen stellen nun Kondensatorplatten dar. Die Kapazität des Kondensators ändert sich, wenn ein Benutzerfinger mit ihr interagiert. Je nach Größe und Verteilung der Flächen sowie der Programmierung der Auswerteelektronik, können Körper unterschiedlicher Größe und sogar deren Bewegungsrichtung erkannt werden. Wenn zwischen den Sensorflächen und dem Bedienerfinger nur ein geringer Abstand herrscht (Lackschicht), wird die Empfindlichkeit des Sensors sogar noch erhöht. Beim Einsatz eines solchen Sensors in einer Schalteranordnung, insbesondere in einem Fahrzeug, ist es wünschenswert, den Schalter beleuchtbar zu gestalten. Die in der Technik weitverbreitete Methode, Schalterköpfe von innen heraus zu beleuchten, funktioniert hier nicht. Die Leiterplatte und insbesondere die Kupferbeschichtung sind Licht undurchlässig. Eine gängige Methode dieses Problem zu lösen, ist der Einsatz einer Plexiglasscheibe, die vor der Sensorfläche angeordnet wird und in die seitlich Licht eingekoppelt wird. Ein auf der Scheibe aufgebrachtes Symbol wird dadurch in der Dunkelheit sichtbar gemacht. Damit diese Anordnung akzeptabel funktioniert, muss die Plexiglasscheibe eine Minimalstärke aufweisen. Der größere Abstand, der dadurch zwischen Sensoroberfläche und Benutzerfinger entsteht, führt zu einer schlechteren Detektionsgenauigkeit. Außerdem benötigt die Plexiglasscheibe sowie die Lichtquelle, die gewöhnlich seitlich an der Plexiglasscheibe angeordnet ist, Raum, sodass ein entsprechender Schalterkopf eine gewisse Größe nicht unterschreiten kann. Dieser Umstand limitiert die Designoptionen im Fahrzeug.

US2011/0037728 A1 gilt als der nächstliegende Stand der Technik und offenbart eine kapazitive Abtastvorrichtung mit einem Lichtleiter zur Beleuchtung.

Die Aufgabe der Erfindung kann darin gesehen werden, eine Betätigungsplatte für einen Sensorschaltknopf mit hoher Detektionsempfindlichkeit und Auflösung bereitzustellen, der über eine Beleuchtungsmöglichkeit verfügt.

Die Aufgabe wird durch den Gegenstand des Anspruchs 1 gelöst, insbesondere durch eine Betätigungsplatte mit Symbolbeleuchtung für einen Sensorschaltknopf, umfassend eine Trägerplatte mit einer ersten Oberfläche, auf der eine Metalschicht aufgebracht ist. Auf der Trägerplatte und zumindest bereichsweise auf der Metalschicht ist eine Leuchtschicht aus lichtstreuendem Material angebracht. Durch die Trägerplatte erstreckt sich eine Öffnung, durch die ein erstes Ende eines Lichtleiters ragt, ein zweites Ende des Lichtleiters ist optisch mit einer Lichtquelle verbunden, wobei die Leuchtschicht an das erste Ende des Lichtleiters angrenzt.

Die erfindungsgemäße Betätigunsplatte stellt für sich genommen ein Modul dar, welches durch eine zugeordnete Steuereinheit, z. B. in der eingangs erläuterten Weise, zur kapazitiven Detektion verwendet werden kann. Die auf der Trägerplatte aufgebrachte Metallschicht dient als Sensorelektrode. Um eine hohe Detektionsempfindlichkeit und Auflösung der Betätigungsplatte zu erhalten, ist die Metallschicht über die ganze Oberfläche der Trägerplatte verteilt. Zum Schutz der Metallschicht und aus ästhetischen Gründen ist die Betätigungsplatte mit einer Kunststoffbeschichtung versehen. Es können natürlich auch Lacke verwendet werden, um die Schichtdicke noch geringer zu halten. Der Bereich, der für die Leuchtschicht vorgesehen ist, wird nicht beschichtet. Hier wird eine Leuchtschicht aus einem lichtstreunenden Material angebracht. Lichtstreunende Materialien sind in der Beleuchtungstechnik bekannt. Die Leuchtschicht kann zum Beispiel scheibenförmig ausgeführt sein oder jede gewünschte Form aufweisen. Die Betätigungsplatte weist eine Öffnung auf durch die ein Lichtleiterende ragt, die Leuchtschicht ist an der Trägerplatte so angeordnet, dass Licht aus dem Lichtleiter in die Leuchtschicht eingekoppelt werden kann. Eingekoppelt bedeutet, dass das Licht aus dem Lichtleiter in die Leuchtschicht scheinen kann. Das Licht wird dann in der Leuchtschicht diffus verteilt und als leuchtende Fläche vom Bediener wahrgenommen. Das zweite Ende des Lichtleiters ist mit einer Lichtquelle verbunden, die das Licht in den Lichtleiter einkoppelt. Als Lichtquellen werden heutzutage hauptsächlich Leuchtdioden wegen ihrer geringen Baugröße verwendet. Vorteilhafterweise kann die Lichtquelle auf der zweiten Seite der Trägerplatte angeordnet werden, was zu einer besonders kompakten Bauform führt. Es können aber prinzipiell alle Arten von Lichtquellen verwendet werden. Um ein besonders vorteilhaftes Beleuchtungsergebnis zu erhalten, wird das zweite Ende des Lichtleiters im Randbereich der Leuchtschicht angeordnet. Dadurch vermeidet man Lichtspots mitten in der Leuchtschicht, die ästhetisch unschön aussehen.

Vorteilhafte Ausbildungen der Erfindung sind den Unteransprüchen, der Beschreibung und der Zeichnung zu entnehmen.

Gemäß einer Ausführungsform erstreckt sich die Öffnung durch die Metalschicht. Je nach Verteilung der Metallflächen auf der Trägerplatte und der gewünschten Position der Leuchtschicht, kann es notwendig werden, die Öffnung auch durch die Metallfläche vorzusehen. Da die Öffnung relativ zur Fläche der Metallfläche klein ist, wird die Sensorleistung nicht wesentlich beeinflusst.

Bevorzugt weist die Leuchtschicht eine Schichtdicke von 1 bis 2 mm auf. Die Leuchtschicht muss eine gewisse Schichtdicke aufweisen, um eine akzeptable Lichtverteilung im diffusen Material zu gewährleisten.

Nach einer weiteren Ausführungsform weist die Leuchtschicht einen kreisförmigen Umfang auf, wobei die Schichtdicke der Leuchtschicht ein Zehntel des Durchmessers der Leuchtschicht beträgt. Wird die Leuchtschicht mit kreisförmigem oder eliptischem Umfang ausgeführt, dann kann davon ausgegangen werden, das der Aufbau nach vorgeschlagenem Verhältnis ein gutes Beleuchtungsergebnis erziehlt.

Bevorzugt ist die Trägerplatte in dem Bereich in dem die Leuchtschicht an die Metalschicht und/oder an die Trägerplatte angrenzt frei von Öffnungen. Die Betätigungsplatte muss auch im Bereich der Leuchtschicht funktionsfähig sein, damit Personen im Dunkeln einen Schalter zuverlässig bedienen können. Ohne Öffnung in diesem Bereich ist maximale Sensorfläche möglich.

Nach einer weiteren Ausführungsform ist die Lichtquelle so an der zweiten Oberfläche befestigt, das dass emitierte Licht direkt in die Öffnung strahlt. Bei Verwendung einer (Reverse Gullwing) LED strahlt diese die Leiterplatte auf der sie befestigt ist an. Wird die LED über der Öffnung positioniert, dann strahlt sie durch die Öffnung hindurch. Da sich in der Öffnung ein Lichtleiter befindet, wird das Licht geführt, dieses verbessert die Effizienz. Die Öffnung verläuft im Wesentlichen senkrecht zur Trägerplatte. Senkrechte Bohrungen lassen sich in der Produktion am einfachsten herstellen. Schräg verlaufende Bohrungen könnten bei Bedarf allerdings auch vorgesehen werden, wobei die Einkoppelfläche parallel zur Lichtquelle bleiben sollte.

Bevorzugt ist die Leuchtschicht beabstandet vom Rand der Trägerplatte angebracht. Im Allgemeinen sind Symbolbeleuchtungen zentral auf einem Schalter angeordnet, um den Bediener im Dunkeln schnell zum Betätigungspunkt zu führen.

Nach einer weiteren Ausführungsform breitet sich die Leuchtschicht konisch oder gewölbt von der Trägerplatte aus. Die Leuchtschicht hat bei dieser Ausführungsform eine kleinere, der Trägerplatte zugewandte Fläche und eine größere, dem Benutzer zugewandte Fläche. Dieser Aufbau hat den Vorteil, dass wenn die Leuchtschicht als Einlegeteil ausgeführt ist, dieses Teil bei der Montage der Betätigungsplatte leicht in eine entsprechende schalenförmige Aufnahme in der Kunstoffbeschichtung positioniert und befestigt werden kann. Des Weiteren kann das Ende des Lichtleiters besser an den schräg verlaufenden Randbereich angepasst werden.

Bevorzugt weist das erste Ende des Lichtleiters eine Auskoppelfläche auf, die komplementär zur Seitenwand der Leuchtschicht geformt ist. Der Begriff Komplementär ist hier dahingehend zu verstehen, dass die Flächen so ausgebildet sind, dass sie zusammengefügt eine möglichst große Verbindungsfläche aufweisen, wobei der trennende Luftspalt möglichst gering sein soll. Einige Beispiele:
- Der Randbereich der Leuchtschicht weist eine ebene Fläche auf und das erste Ende des Lichtleiters weist ebenfalls eine ebene Fläche auf, wobei die beiden ebenen Flächen im wesentlichen gleich groß sind.
   - Der Randbereich der Leuchtschicht weist eine Wölbung auf (im Falle einer zylinderförmigen Leuchtschicht) und das erste Ende des Lichtleiters weist eine Ausnehmung auf, die sich an die Wölbung anschmiegt.
- Der Randbereich der Leuchtschicht weist eine Ausnehmung auf (im Falle einer zylinderförmigen Leuchtschicht) und das erste Ende des Lichtleiters weist eine Wölbung auf, die sich an die Ausnehmung anschmiegt.
- Die Leuchtschicht erstreckt sich in einem Winkel von 45 Grad zur Trägerplattenebene zum Rand und das erste Ende des Lichtleiters weist einen Winkel von 45 Grad auf. Dieser Aufbau macht es möglich, das erste Ende des Lichtleiters so an den Rand der Leuchtschicht zu positionieren, dass die größtmögliche Koppelfläche erreicht wird, wenn die Flächen komplementär ausgeführt werden.

Vorteilhafterweise weist der Lichtleiter meherere erste Enden auf, die entlang des Umfangs der Leuchtschicht angeordnet sind. Zum Erreichen einer homogenen Ausleuchtung der Leuchtschicht ist es von Vorteil, mehrere Koppelstellen vorzusehen. Werden mehrere Stellen entlang des Umfanges der Leuchtschicht mit Licht versorgt, wird eine ansprechende Symbolbeleuchtung erreicht.

Bevorzugt enthält die Leuchtschicht einen Leuchtstoff, der dazu geeignet ist, aus höherenergetischem Licht weißes Licht zu erzeugen. Bei einigen Anwendungen kann es einfacher sein, UV Licht oder blaues Licht durch den Lichtleiter zu transportieren und das Licht dann in der Leuchtschicht in weißes Licht zu wandeln. Das diffuse Material oder Diffusermaterial müsste dann mit entsprechenden Komponenten versehen werden, die in der Technik bekannt sind.

Bevorzugt ist die Trägerplatte eine Leiterplatte mit mehreren, die erste Oberfläche weitgehed bedeckenden, eng aneinanderliegenden Leiterflächen, die Sensorfläche eines kapazitiven Sensors bildet. Eine kostengünstige Betätigungsplatte lässt sich herstellen, wenn als Trägerplatte eine handelsübliche Leiterplatte mit Kupferkaschierung verwendet wird. Die Kondensatorplatten des Sensors werden durch die Kupferflächen gebildet. Je nach Anforderung können unterschiedliche Layouts für die Verteilung der Leiterflächen erstellt werden.

Bevorzugt ist die Querschnittsfläche der Öffnung wesentlich kleiner als eine Fläche der Leiterflächen des kapazitiven Sensors. Damit die Betätigungsplatte bestmöglich funktioniert, sollte die Sensorfläche so homogen wie möglich sein. Wenn Öffnungen für die Symbolbeleuchtung vorgesehen werden müssen, sollten sie so klein wie möglich gestaltet werden. Die Öffnungen sollten einen Durchmesser von 1,5 mm nicht überschreiten. Bei nicht kreisförmigen Öffnungen sollte die Fläche der Öffnung unter 2mm2 bleiben.

Vorteilhafterweise ist die Betätigungsplatte beweglich angeordnet und der Lichtleiter aus mindestens einer Polymere-Optischen-Faser gebildet. Die Betätigungsplatte kann in einen Schalter integriert werden, der eine mechanische Schaltfunktion bereitstellt. Um dem Benutzer die Haptik zu suggerieren, einen Schalter zu betätigen, muss sich der Schalter bewegen. Je nach Platzverhältnissen kann es notwendig sein, die Lichtquelle zur Symbolbeleuchtung entfernt oder unbeweglich zu platzieren. Mittels einer Polymere-Optischen-Faser kann die bewegliche Betätigungsplatte trotzdem mit Licht versorgt werden. Die nötige Flexibilität wird durch die Polymere-Optische-Faser bereitgestellt.

Die Leuchtschicht, sowie die Kappe kann mittels eines symbolgebendem Verfahren mit einer dekorativen Schicht versehen werden. Diese Verfahren benutzen eine Lackschicht in die, mittels Laser, Symbole eingeprägt werden.

Die Erfindung betrifft ferner einen Sensorschaltknopf umfassend eine Betätigungsplatte.

Nachfolgend wird die Erfindung anhand einer vorteilhaften Ausführungsform rein beispielhaft unter Bezugnahme auf die beigefügte Zeichnung beschrieben. Es zeigen:
Fig. 1 zeigt einen Sensorschaltknopf mit integrierter Betätigungsplatte und Symbolbeleuchtung in einer Schnittdarstellung.
Fig. 2 zeigt eine Draufsicht auf eine Betätigungsplatte.
Fig. 3 zeigt den Aufbau einer Betätigungsplatte mit Symbolbeleuchtung in Schnittdarstellung.
Fig. 4 zeigt einen alternativen Aufbau eines Sensorschaltknopfs mit Betätigungsplatte und Symbolbeleuchtung.
Fig. 5 zeigt ein eine Draufsicht auf eine Betätigungsplatte.
Fig. 6 zeigt das erste Ende eines Lichtleiters und den angrenzenden Bereich der Leuchtschicht.

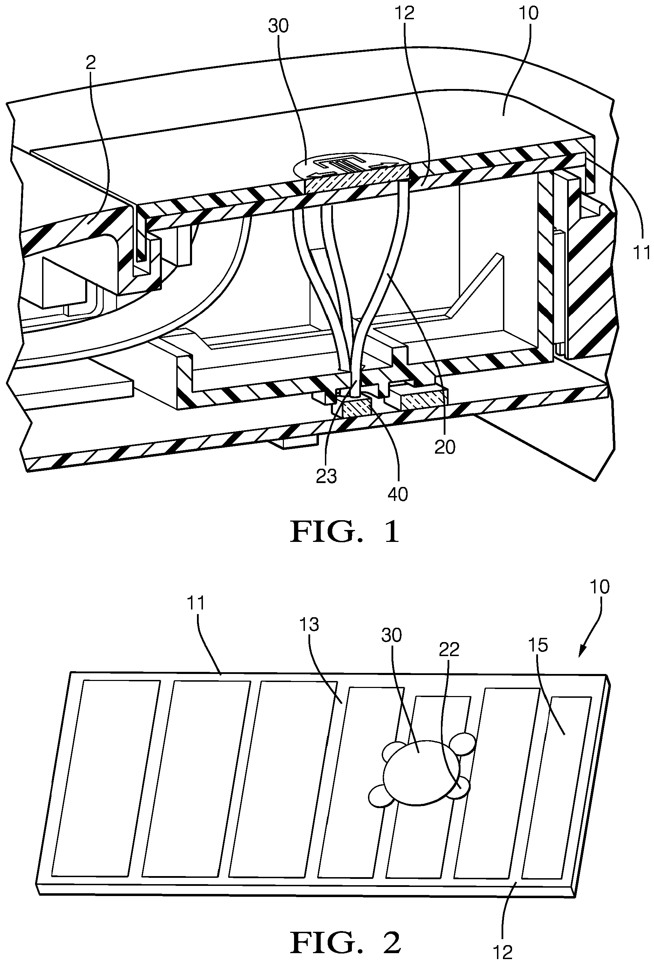

Fig. 1 zeigt einen Sensorschaltknopf 1 mit integrierter Betätigungsplatte 10 und Symbolbeleuchtung. Die ersten Oberfläche 13 der Betätigungsplatte 10 wird durch eine Kappe 17 abgedeckt. Die Kappe 17 dient zum Schutz der Sensorfläche sowie zum Halten der Betätigungsplatte 10 am Gehäuse 2 des Schalters. Die Kappe 17 weist in mittleren Bereich der Fläche eine Ausnehmung auf, in die eine Leuchtschicht 30 eingebettet ist. Ausgehend von einer Lichtquelle 40, die an einer zweiten Leiterplatte befestigt ist, erstrecken sich Lichtleiter 20 in Richtung der Betätigungsplatte 10. Die Lichtleiter 20 erreichen die Betätigungsplatte 10 an der zweiten Oberfläche 13b. Bei dieser Ausführungsform ist die Betätigungsplatte 10 beweglich mit dem Gehäuse 2 verbunden. Die Lichtleiter 20 sind hier aus flexiblen Polymere-Optischen-Faser gebildet.

Fig. 2 zeigt eine Draufsicht auf die erste Oberfläche 13 der Betätigungsplatte 10. Auf einer Trägerplatte 12 sind mehrere Metallschichten 15 aufgebracht, die durch schmale Bereiche voneinander getrennt sind. Die Metallschichten 15 sind hier als eine Reihe von Streifen dargestellt. Diese Leiterflächen 16 bildeten die Sensorelemente eines Kapazitätssensors. Zentral auf der ersten Oberfläche 13 und beanstandet vom Rand 11 der Trägerplatte 12 ist eine Leuchtschicht 30 dargestellt. Am Rand der Leuchtschicht 30 sind mehrere erste Enden 22 eines Lichtleiters 20 dargestellt. Die ersten Enden 22 sind hier gleichmäßig entlang des Umfangs der Leuchtschicht 30 angebracht.

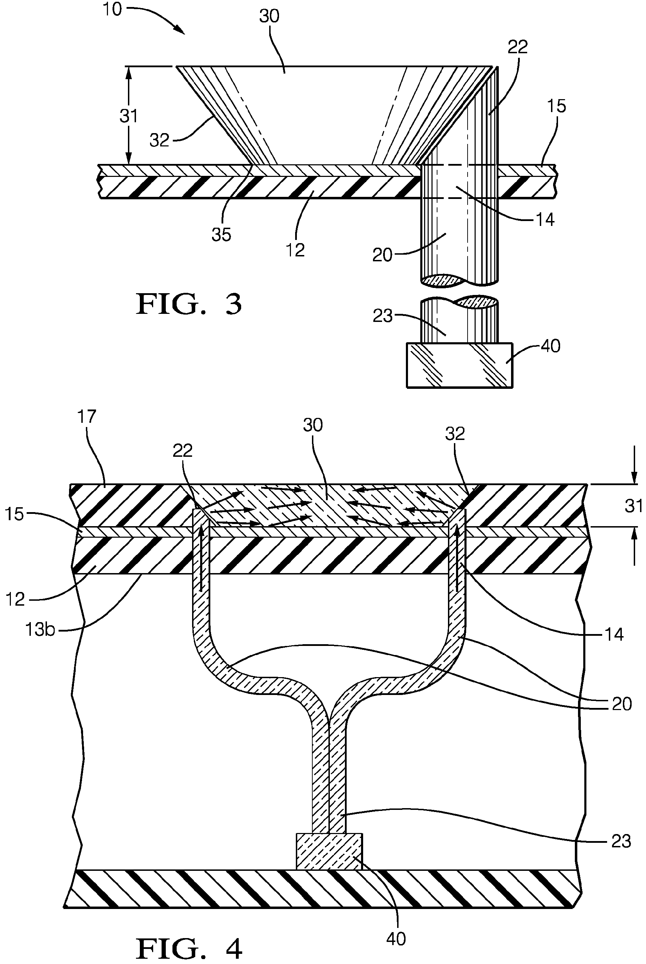

Fig. 3 zeigt den grundsätzlichen Aufbau einer Betätigungsplatte 10 mit Symbolbeleuchtung in Schnittdarstellung. Eine Leuchtschicht 30 ist an der ersten Oberfläche 13 einer Trägerplatte 12 angebracht. Die Leuchtschicht 30 liegt idealerweise auf der Trägerplatte 12 und / oder auf der Metallschicht auf. Entlang des Umfangs der Leuchtschicht 30, die an die Trägerplatte 12 angrentzt, verläuft ein Randbereich 35. Angrenzend an den Randbereich 35 der Leuchtschicht 30 ist eine Öffnung 14 in der Trägerplatte 12 eingebracht, durch die das erste Ende 22 eines Lichtleiters 20 ragt. Das erste Ende 22 des Lichtleiters 20 und die Seitenwand 32 der Leuchtschicht 30 sind so geformt, dass sich das erste Ende 22 des Lichtleiters 20 an die Seitenwand 32 schmiegt. Das zweite Ende 23 des Lichtleiters 20 ist mit einer Lichtquelle 40 optisch verbunden.

Fig. 4 zeigt einen alternativen Aufbau eines Sensorschaltknopfs 1 mit Betätigungsplatte 10 und Symbolbeleuchtung in einer Schnittdarstellung. Zur Verbesserung der Ausleuchtung der Symbolbeleuchtung ist hier ein Aufbau mit zwei ersten Lichtleiter 20 Enden 22 dargestellt. Die ersten Enden 22 des Lichtleiters 20 sind an gegenüberliegenden Seitenwänden der Leuchtschicht 30 angebracht. Die Lichtleiter vereinigen sich im Lichtleiter 20 und bilden ein einziges zweites Lichtleiter Ende 23. Das zweite Lichtleiter Ende ist optisch mit einer Lichtquelle 40 verbunden. Eine Kappe 17 liegt, die Leuchtschicht 30 umgebend, im Bereich außerhalb der Leuchtschicht 30 auf der ersten Oberfläche 13 um diese zu schützen. Die Schichtdicke der Kappe 17 ist auf die Schichtdicke 31 der Leuchtschicht 30 abgestimmt.

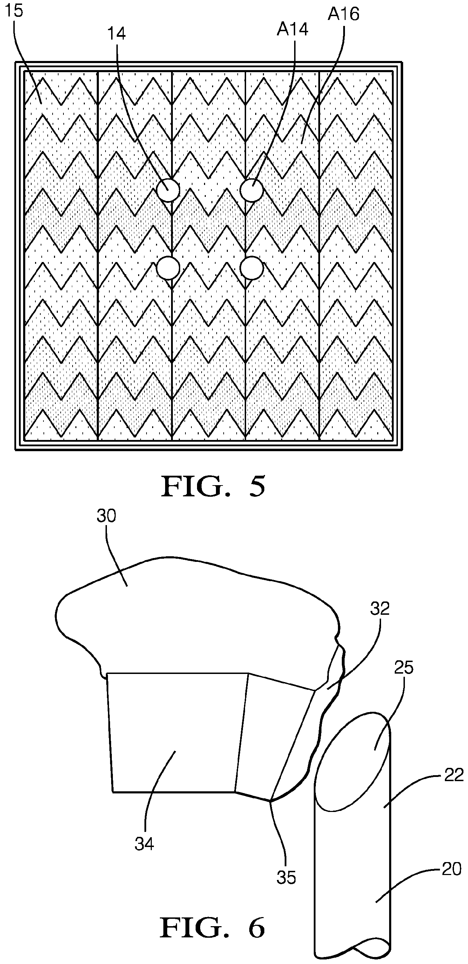

Fig. 5 zeigt ein eine Draufsicht auf eine Betätigungsplatte 10. Bei dieser Draufsicht auf die erste Oberfläche 13 der Betätigungsplatte 10 sind die Öffnungen 14 ohne die ersten Enden 22 des Lichtleiters 20 zu sehen. Die die Leiterflächen 16 bedecken nahezu die gesamte erste Oberfläche 13 der Trägerplatte 12. Die Öffnungen 14 erstrecken sich durch die Trägerplatte 12 sowie bereichsweise zusätzlich durch die Leiterflächen 16. Die Leiterflächen 16 beanspruchen sehr viel größere Bereiche als die Öffnungen 14.

Fig. 6 zeigt das erste Ende 22 eines Lichtleiters 20 und den angrenzenden Bereich der Leuchtschicht 30. Das erste Ende 22 des Lichtleiters 20 ist so präpariert, dass es mit der Seitenwand 32 der Leuchtschicht 30 korrespondiert. Was bedeutet, dass die größtmögliche Lichtmenge von der Auskoppelfläche 25 des ersten Endes 22 des Lichtleiters 20 in die Einkoppelfläche 34 der Leuchtschicht 30 übertragen wird. Hier wird das erste Lichtleiterende 22 in einem Winkel mit einer planen Fläche versehen. Die Seitenwand 32 der Leuchtschicht 30 wird an entsprechender Position ebenfalls mit einer planen Ebene versehen, die in einem korrespondierenden Winkel angeordnet ist. Werden diese beiden Flächen aneinander angeordnet, wird die größte Lichtmenge übertragen.

## Patentansprüche

1. Betätigungsplatte (10) mit Symbolbeleuchtung für einen Sensorschaltknopf (1), umfassend eine Trägerplatte (12), durch die sich eine Öffnung (14) erstreckt, wobei auf einer ersten Oberfläche (13) der Trägerplatte (12), eine Metallschicht (15) aufgebracht ist, wobei auf der Trägerplatte und zumindest bereichsweise auf der Metallschicht (15) eine Leuchtschicht (30) aus lichtstreuendem Material angebracht ist auf die erste Oberfläche (13) und wobei durch die Öffnung (14) ein erstes Ende (22) eines Lichtleiters (20) ragt, ein zweites Ende (23) des Lichtleiters ist optisch mit einer Lichtquelle (40) verbunden, wobei die Leuchtschicht (30) an das erste Ende (22) des Lichtleiters angrenzt, wobei die Trägerplatte (12), in dem Bereich in dem die Leuchtschicht (30) auf die Metallschicht (15) oder auf die Trägerplatte aufgebracht is, frei von Öffnungen ist.

2. Betätigungsplatte (10) nach Anspruch 1, wobei sich die Öffnung (14) durch die Metallschicht (15) erstreckt.

3. Betätigungsplatte (10) nach einem der vorhergehenden Ansprüche, wobei die Leuchtschicht (30) eine Schichtdicke (31) von 1 bis 2 mm aufweist.

4. Betätigungsplatte (10) nach Anspruch 1 oder 2, wobei die Leuchtschicht (30) einen kreisförmigen Umfang aufweist, wobei die Schichtdicke (31) der Leuchtschicht (30) ein Zehntel des Durchmessers der Leuchtschicht beträgt.

5. Betätigungsplatte (10) nach einem der vorhergehenden Ansprüche, wobei die Leuchtschicht (30) beabstandet vom Rand (11) der Trägerplatte (12) angebracht ist.

6. Betätigungsplatte (10) nach einem der vorhergehenden Ansprüche, wobei sich die Leuchtschicht (30) konisch oder gewölbt von der Trägerplatte (12) ausbreitet.

7. Betätigungsplatte (10) nach einem der vorhergehenden Ansprüche, wobei das erste Ende (22) des Lichtleiters eine Auskoppelfläche (25) aufweist, die komplementär zur Seitenwand (32) der Leuchtschicht (30) geformt ist.

8. Betätigungsplatte (10) nach einem der vorhergehenden Ansprüche, wobei der Lichtleiter (20) mehrere erste Enden (22) aufweist, die endlang des Umfangs der Leuchtschicht (30) angeordnet sind.

9. Betätigungsplatte (10) nach einem der vorhergehenden Ansprüche, wobei die Leuchtschicht (30) Leuchstoff enthält, der dazu geeignet ist, aus höherenergetischem Licht weißes Licht zu erzeugen.

10. Betätigungsplatte (10) nach einem der vorhergehenden Ansprüche, wobei die Trägerplatte (12) eine Leiterplatte ist und mit mehreren, die erste Oberfläche (13) weitgehed bedeckenden, eng aneinanderliegenden Leiterflächen (16) dieSensorfläche eines kapazitiven Sensors bildet.

11. Betätigungsplatte (10) nach Anspruch 10, wobei eine Querschnittsfläche (A14) der Öffnung (14) kleiner ist, als eine Fläche (A16) der Leiterflächen (16) des kapazitiven Sensors.

12. Betätigungsplatte (10) nach einem der vorhergehenden Ansprüche, wobei die Betätigungsplatte (10) beweglich angeordnet ist und der Lichtleiter (20) aus mindestens einer Polymere-Optischen-Faser gebildet ist.

13. Sensorschaltknopf (1) umfassend eine Betätigungsplatte (10) nach einem der vorhergehenden Ansprüche.

## Claims

1. Actuation plate (10) with symbol illumination for a sensor switch button (1), said plate comprising a support plate (12), through which an opening (14) extends, wherein a metal layer (15) is applied on a first surface (13) of the support plate (12), wherein a luminous layer (30) of light-scattering material is applied on the first surface (13) of the support plate and at least partially on the metal layer (15), and wherein a first end (22) of a light guide (20) projects through the opening (14) and a second end (23) of the light guide is optically connected to a light source (40), wherein the luminous layer (30) is adjacent to the first end (22) of the light guide, wherein the support plate (12) is without openings in the area in which the luminous layer (30) is applied on the metal layer (15) or on the support plate.

2. Actuation plate (10) according to claim 1, wherein the opening (14) extends through the metal layer (15).

3. Actuation plate (10) according to one of the preceding claims, wherein the luminous layer (30) has a layer thickness (31) of 1 to 2 mm.

4. Actuation plate (10) according to claim 1 or 2, wherein the luminous layer (30) has a circular circumference, wherein the layer thickness (31) of the luminous layer (30) is one tenth of the diameter of the luminous layer.

5. Actuation plate (10) according to one of the preceding claims, wherein the luminous layer (30) is spaced apart from the edge (11) of the support plate (12).

6. Actuation plate (10) according to one of the preceding claims, wherein the luminous layer (30) spreads conically or curved from the support plate (12).

7. Actuation plate (10) according to one of the preceding claims, wherein the first end (22) of the light guide has a decoupling surface (25) that is formed complementary to the side wall (32) of the luminous layer (30).

8. Actuation plate (10) according to one of the preceding claims, wherein the light guide (20) has a plurality of first ends (22) which are arranged along the circumference of the luminous layer (30).

9. Actuation plate (10) according to one of the preceding claims, wherein the luminous layer (30) contains luminescent material which is suitable to produce white light from higherenergy light.

10. Actuation plate (10) according to one of the preceding claims, wherein the support plate (12) is a printed circuit board and forms the sensor surface of a capacitive sensor with a plurality of closely spaced conductor surfaces (16) largely covering the first surface (13).

11. Actuation plate (10) according to claim 10, wherein a cross-sectional area (A14) of the opening (14) is smaller than a surface area (A16) of the conductor surfaces (16) of the capacitive sensor.

12. Actuation plate (10) according to one of the preceding claims, wherein the actuation plate (10) is movably arranged and the light guide (20) is formed of at least one polymer optical fiber.

13. Sensor switch button (1) comprising an actuation plate (10) according to one of the preceding claims.

## Revendications

1. Plaque d'actionnement (10) avec éclairage de symboles pour un bouton de commutation de capteur (1), comprenant une plaque de support (12) à travers laquelle s'étend une ouverture (14), dans laquelle une couche métallique (15) est appliquée sur une première surface (13) de la plaque de support (12), dans laquelle sur la plaque de support et au moins par endroits sur la couche métallique (15) une couche luminescente (30) dans un matériau dispersant la lumière est appliquée sur la première surface (13), et dans laquelle à travers l'ouverture (14) une première extrémité (22) d'un conducteur de lumière (20) fait saillie, une seconde extrémité (23) du conducteur de lumière est optiquement reliée à une source lumineuse (40), dans laquelle la couche luminescente (30) est contiguë à la première extrémité (22) du conducteur de lumière, dans laquelle la plaque de support (12) est exempte d'ouvertures dans la zone dans laquelle la couche luminescente (30) est appliquée sur la couche métallique (15) ou sur la plaque de support.

2. Plaque d'actionnement (10) selon la revendication 1, dans laquelle l'ouverture (14) s'étend à travers la couche métallique (15).

3. Plaque d'actionnement (10) selon l'une des revendications précédentes, dans laquelle la couche luminescente (30) présente une épaisseur de couche (31) de 1 à 2 mm.

4. Plaque d'actionnement (10) selon la revendication 1 ou 2, dans laquelle la couche luminescente (30) présente un pourtour circulaire, dans laquelle l'épaisseur de couche (31) de la couche luminescente (30) s'élève à un dixième du diamètre de la couche luminescente.

5. Plaque d'actionnement (10) selon l'une des revendications précédentes, dans laquelle la couche luminescente (30) est appliquée à distance du bord (11) de la plaque de support (12).

6. Plaque d'actionnement (10) selon l'une des revendications précédentes, dans laquelle la couche luminescente (30) se déploie de façon conique ou bombée depuis la plaque de support (12).

7. Plaque d'actionnement (10) selon l'une des revendications précédentes, dans laquelle la première extrémité (22) du conducteur de lumière présente une surface d'extraction (25) qui est formée en complément de la paroi latérale (32) de la couche luminescente (30).

8. Plaque d'actionnement (10) selon l'une des revendications précédentes, dans laquelle le conducteur de lumière (20) présente plusieurs premières extrémités (22) qui sont agencées le long du pourtour de la couche luminescente (30).

9. Plaque d'actionnement (10) selon l'une des revendications précédentes, dans laquelle la couche luminescente (30) contient une substance luminescente qui est conçue pour produire une lumière blanche à partir d'une lumière dont l'énergie est plus élevée.

10. Plaque d'actionnement (10) selon l'une des revendications précédentes, dans laquelle la plaque de support (12) est une plaque conductrice et forme, avec plusieurs surfaces conductrices (16) étroitement rapprochées et recouvrant largement la première surface (13), la surface de capteur d'un capteur capacitif.

11. Plaque d'actionnement (10) selon la revendication 10, dans laquelle une surface transversale (A14) de l'ouverture (14) est plus petite qu'une surface (A16) des surfaces conductrices (16) du capteur capacitif.

12. Plaque d'actionnement (10) selon l'une des revendications précédentes, dans laquelle la plaque d'actionnement (10) est agencée de façon mobile et le conducteur de lumière (20) est formé d'au moins une fibre optique polymère.

13. Bouton de commutation de capteur (1) comprenant une plaque d'actionnement (10) selon l'une des revendications précédentes.
